# EUROPÄISCHE PATENTSCHRIFT

(11) **EP 1 037 140 B1**
(45) Veröffentlichungstag und Bekanntmachung des Hinweises auf die Patenterteilung: **08.08.2012**
(21) Anmeldenummer: 00105452.7
(22) Anmeldetag: 15.03.2000
(51) Int. Cl.: G06F 11/14, G11C 16/10

(54) **Verfahren und Vorrichtung zur Absicherung bei Veränderung des Speicherinhalts von Steuergeräten**
Method and apparatus providing security during modification of memory contents in control devices
Procédé et appareil pour sécurisation pendant la modification de données emmagasinées dans une mémoire de dispositif de commande

(30) Priorität: 17.03.1999 DE 19911794
(43) Veröffentlichungstag der Anmeldung: 20.09.2000
(73) Patentinhaber: ROBERT BOSCH GMBH, 70442 Stuttgart (DE)
(72) Erfinder: Kohler, Rolf, 71701 Schwieberdingen (DE); Braun, Guenter, 74321 Bietigheim (DE); Kottmann, Matthias, 73240 Wendlingen (DE)

(56) Entgegenhaltungen:
- EP-A- 0 664 387
- DE-A1- 19 619 354
- PATENT ABSTRACTS OF JAPAN Bd. 1997, Nr. 10, 31. Oktober 1997 (1997-10-31) & JP 09 161493 A (FUJITSU TEN LTD), 20. Juni 1997 (1997-06-20)

## Beschreibung

### Stand der Technik

Die vorliegende Erfindung betrifft Verfahren und zugehörige Vorrichtung zum Programmieren von Daten in einen nicht-flüchtigen Speicher eines Rechners gemäß den Oberbegriffen der Ansprüche. Dabei werden Daten und/oder Programme in einem Speicher eines Rechners, insbesondere eines Steuergeräts in einem Fahrzeug, verändert. Bei der Programmierung wird eine Kennung, die das korrekte Löschen und/oder Programmieren des Speichers kenntlich macht, in den Speicher eingeschrieben.

In der DE 196 19 354 A1 wird ein Verfahren zum Betreiben eines eine Steuerfunktion aufweisenden Steuergerätes mit einer programmierbaren Speichereinrichtung zum Speichern von, für die Ausübung der Steuerfunktion erforderlichen Steuerfunktionsprogrammen und Steuerfunktionsdaten, beschrieben. Das beschriebene Verfahren zeichnet sich dadurch aus, daß einhergehend mit dem Einschreiben der Steuerfunktionsprogramme und Steuerfunktionsdaten in die Speichereinrichtung an vorbestimmte Stellen innerhalb der Speichereinrichtung bestimmte, nicht zu den Steuerfunktionsprogrammen und Steuerfunktionsdaten gehörende Selbststeuerdaten eingeschrieben werden. In Abhängigkeit davon, ob an den vorbestimmten Stellen die bestimmten Selbststeuerdaten gespeichert sind wird dann das Steuergerät betrieben. Da die Selbststeuerdaten in der genannten Offenlegungsschrift nicht Bestandteil der eigentlich abzuspeichernden Steuerfunktionsprogramme und Steuerfunktionsdaten, also der Nutzdaten, sondern als gesondertes Bitmuster vorgesehen sind, benötigen diese zusätzlichen Speicherplatz. Eine Überprüfung der Selbststeuerdaten verhindert dabei den Versuch einer Ausführung von nicht ordnungsgemäß zugänglichen oder nicht in der Speichereinrichtung abgespeicherten Nutzdaten. Die Ursache bzw. der Zeitpunkt des Auftretens der nicht zugänglichen bzw. nicht abgespeicherten Nutzdaten wird dabei nicht registriert. Das vorgeschlagene Verfahren wird darüber hinaus nur bei Speichereinrichtungen oder Teilen davon eingesetzt, die vor der Programmierung vollständig gelöscht werden müssen. Ein einfaches Überprogrammieren, also Überschreiben der Daten ist nicht vorgesehen. Ziel ist dabei trotz einer in Teilen fehlerhaften Programmierung eine Art Notsteuerprogramm durchzuführen, wobei dazu nur die funktionsfähigen Daten verwendet werden.

Daneben zeigt die DE 196 23 145 A1 ein Verfahren zum Betreiben eines Steuergeräts mit einer über eine Programmiervorrichtung programmierbaren Speichereinrichtung, bei der das Löschen und das Überschreiben des Inhalts der Speichereinrichtung jeweils unter Ausführung eines Programmabschnitts zur Datenverarbeitung und unter Verwendung von Daten durchgeführt wird. Das beschriebene Verfahren zeichnet sich dadurch aus, daß wenigstens entweder der Programmabschnitt zur Datenverarbeitung oder die Daten derart bereitgestellt werden, daß sie vor deren Verwendbarkeit zur Herbeiführung eines Löschens oder eines Überschreibens einer Modifikation bedürfen. Diese Modifikation wird erst dann durchgeführt, wenn festgestellt wird, daß ein Einsprung in dem Programmabschnitt zur Datenverarbeitung bestimmungsgemäß erfolgt ist oder erfolgen wird bzw. erfolgen kann. Da dabei eine Modifikation der einzuschreibenden Daten erfolgt und nicht der bereits eingeschriebenen Daten, kann eine Fehlfunktion oder ein Funktionsausfall infolge einer Unterbrechung oder Störung bei der Programmierung nicht vermieden werden. Dies umso mehr, als daß auch hierbei die Unterbrechung oder Störung nicht im Speicher vermerkt wird. Die Modifikation wird in der genannten Offenlegungsschrift derart eingesetzt, daß ein nicht bestimmungsgemäßes Löschen und/oder Überschreiben von in einer programmierbaren Speichereinrichtung gespeicherten Daten auf einfache Weise zuverlässig ausschließbar ist. Dies ermöglicht aber nicht die Absicherung der Programmierung, wenn diese bereits angestoßen ist, also die Modifikation bereits durchgeführt wurde. Eine dann auftretende Störung oder Unterbrechung hat dann Datenverlust, eine unvollständige Programmierung und somit ein nicht bzw. fehlerhaft Funktionieren des Steuerungsgerätes zur Folge.

Unter anderem aus den genannten Gründen hat sich gezeigt, daß die genannten Verfahren nicht in jeder Beziehung optimale Ergebnisse zu liefern vermögen.

### Vorteile der Erfindung

Die Verfahren und zugehörige Vorrichtung dienen zur Absicherung der Funktionalität beispielsweise eines Steuergerätes, wenn während des Löschens und/oder Programmierens eine Unterbrechung oder Störung aufgetreten ist. Dazu wird einerseits, wenn sich während des Löschens oder Programmierens eine Unterbrechung oder ein Reset ereignet oder das Gerät anderweitig spannungslos wird, dies in einer nicht-flüchtigen Speichereinrichtung, insbesondere in der zu programmierenden Speichereinrichtung selbst vermerkt. Daneben wird bei der Programmierung eine Kennung, die das korrekte Löschen und/oder Programmieren des Speichers kenntlich macht, in einen spät zu löschenden und/oder zu programmierenden Bereich, insbesondere einen als letztes zu löschenden und/oder zu programmierenden Bereich des Speichers eingeschrieben, und diese Kennung wird durch Umprogrammieren vor dem Löschen oder Programmieren der Daten bzw. Programme derart verändert, daß das Programm bei nicht vollständiger Programmierung nicht ausgeführt wird bzw. die Daten bei nicht vollständigem Einschreiben nicht verwendet werden. Somit kann ein Fehler, der beim Programmieren bzw. Löschen selbst auftritt, also nach einer möglichen Datenmodifikation abgefangen werden.

Vorteilhafterweise wird die erwartete Kennung, die die Vollständigkeit bzw. Richtigkeit der Programmierung kennzeichnet, als Bestandteil des Programmes, insbesondere des Programmidentifiers selbst verwendet und verbraucht demzufolge keinen zusätzlichen Speicherplatz.

Vorteilhafterweise kann ein explizites Löschen von Daten und/oder Programmen vor dem zum Programmiervorgang gehörenden Löschen und/oder Programmieren entfallen, weil ein einfaches Unkenntlichmachen der Kennung genügt um ein Abarbeiten des Speicherinhaltes zu verhindern, und dieser demnach nicht gelöscht werden muß. Dadurch können auch Speicher Verwendung finden die ohne vorhergehendes vollständiges Löschen sondern durch einfaches und schnelles Überprogrammieren beschrieben werden können.

Weiterhin von Vorteil ist, daß Zeitpunkt und Ursache der Störung dabei in einem Speicher beispielsweise durch einen Vermerk abgelegt werden können, da in einem besonderen Ausführungsfall eine Anwendung, insbesondere eine Steuerung, nicht mit einem Notsteuerprogramm durchgeführt wird, sondern nur ein wie vorgesehen korrekt beschriebener Speicher bzw. dessen Daten und/oder Programme zur Steuerung ausgelesen bzw. verwendet werden. Dazu kann einerseits die Kennung überprüft und andererseits der Vermerk ausgewertet werden.

Weitere Vorteile ergeben sich aus den Ansprüchen.

### Zeichnung

Anhand der folgenden Figuren der Zeichnung wird der Gegenstand der Erfindung näher erläutert. Dazu zeigt Figur 1 ein Steuergerät mit interner Struktur und optionalem externem Programmiergerät. Figur 2 zeigt eine mögliche Aufteilung eines verwendbaren nicht flüchtigen Speichers in Speicherbereiche. Figur 3 zeigt schematisch eine Auswahl einer Kennung aus einem Daten- bzw. Programmabschnitt, insbesondere aus einer Programmkennung. In Figur 4 ist ein Ablaufdiagramm eines erfindungsgemäßen Verfahrens dargestellt.

### Beschreibung der Ausführungsbeispiele

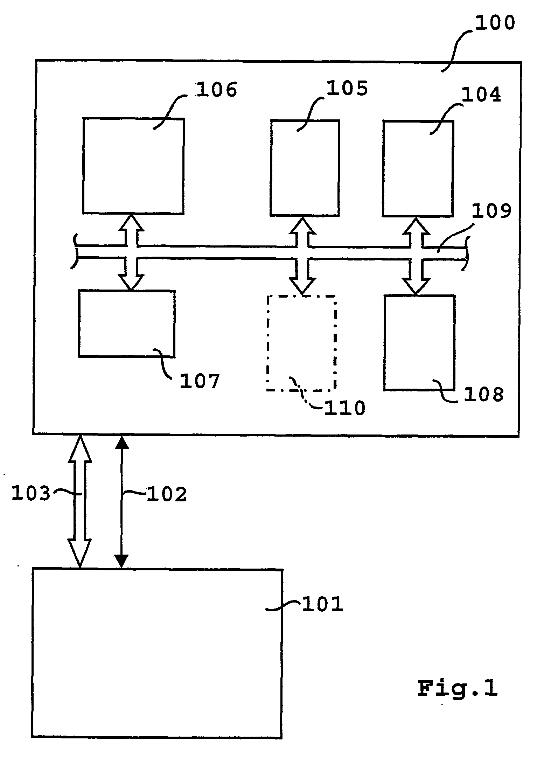

In Figur 1 ist beispielhaft eine Hardwareanordnung zur Umsetzung der vorgestellten Verfahren dargestellt. Darin ist mit 100 ein Computersystem, insbesondere ein Steuergerät, dargestellt. Der innere Aufbau des Steuergerätes 100 kann stark variieren. Zur Darstellung der erfindungswesentlichen Idee ist beispielhaft eine Struktur mit einem Mikroprozessor 106 gewählt. Dieser Mikroprozessor oder Recheneinheit 106 ist über ein Leitungssystem 109, insbesondere ein Bussystem, mit weiteren Elementen verbunden. Die Recheneinheit bzw. der Mikroprozessor 106 kann dabei mit eigenem Speicher, Coprozessor, usw. bestückt sein. Je nach Bauteil- bzw. Funktionsumfang, also abhängig vom eingesetzten Bauelement bzw. der Anwendung sind die Bezeichnungen Mikroprozessorchip (Central Processing Unit), Mikroprozessor, Mikrocontroller, Mikrocomputer, Steuereinheit (Electronic Control Unit), Recheneinheit, etc. für Element 106 beliebig einsetz- und austauschbar. Mit 104, 105 und 108 können verschiedene Speichereinrichtungen im Steuergerät enthalten sein. Dabei stellt 105 einen flüchtigen Speicher z.B. in Form eines RAM, der unter anderem zur Zwischenspeicherung von Daten und/oder Programmen dient, dar. Von dem RAM 105 aus können ebenfalls Programmroutinen gestartet werden. Mit 104 ist ein löschbarer, nicht flüchtiger Speicher, beispielsweise ein Flash-EPROM-Speicher dargestellt. Dabei kann eine Vielzahl von Flash-EPROMs, die sich bezüglich des Löschens und/oder Programmierens stark unterscheiden, eingesetzt werden. Eine erste Art eines Flash-EPROMs 104 muß beispielsweise vor einer neuen Programmierung ganz gelöscht werden. Eine zweite Art des Flash-EPROMs 104 kann beispielsweise blockweise gelöscht und/oder programmiert werden. Eine dritte Art des Flash-EPROMs 104 kann beispielsweise seitenweise programmiert werden, wobei ein explizites Löschen nicht erforderlich ist. Neben dem nicht flüchtigen Speicher 104 kann noch ein weiterer nicht flüchtiger Speicher 108 vorgesehen sein. Dabei besteht die Möglichkeit der Verwendung eines nicht löschbaren Festwertspeichers, beispielsweise durch Verwendung eines ROM und andererseits kann dabei auch ein löschbarer nicht flüchtiger Speicher in Form eines EPROMs, insbesondere eines weiteren Flash-EPROMs verwendet werden. An dieser Stelle sei noch einmal darauf hingewiesen, daß die Anordnung und Verwendung der Speicherbausteine beliebig ist und die Anzahl ebenso reduziert wie erweitert werden kann. Lediglich ein programmierbarer bzw. löschbarer, nicht flüchtiger bzw. refreshbarer Speicher, hier in Form des Elements 104 gezeigt, ist zur Darstellung der Erfindung nötig. Mit Block 107 sind mögliche Peripheriebaugruppen, also Schnittstellenelemente zum Anschluß externer Peripherie, dargestellt. Optional können an das Bussystem 109 weitere Elemente und Baugruppen, beispielhaft dargestellt durch Element 110, beispielsweise in Form von weiteren Peripheriebaugruppen, Speicherelementen, Mikroprozessoren oder Mikrocontrollern, etc. angebunden werden. Die Programmierung ihrerseits kann einerseits über den Einschub eines Datenträgers im Steuergerät 100 selbst oder auch durch Verwendung der Daten aus internen Speichern wie beispielsweise des nicht löschbaren nicht flüchtigen Speichers 108 durchgeführt werden. Neben dieser internen Art der Programmierung kann aber auch entweder seriell über Schnittstelle 102 oder parallel über ein mögliches Bussystem 103 ein externes Programmiergerät 101, beispielsweise ein zweites Steuergerät bzw. Rechner, zur Programmierung und Einschreibung von Daten vorgesehen sein. Bei einer internen Programmierung kann einmal aus einem bereits beschriebenen Datenspeicher wie dem als ROM verwendbaren Speicher 108 ein Satz von Anwenderprogrammen und/oder Daten in den flüchtigen Speicher 105 und/oder in den löschbaren, nicht flüchtigen Speicher 104 geladen und gegebenenfalls dort ausgeführt werden. Ebenso können die Programme und/oder Daten über, an eine mögliche Peripheriebaugruppe 107 anschließbaren Peripherieelemente, z.B. Lesegeräte für Datenträger, wie beispielsweise Diskettenlaufwerk oder CD-ROM mit Hilfe von Datenträgern eingespeist werden. Die selben Möglichkeiten bieten sich selbstverständlich auch für das externe Programmiergerät 101.

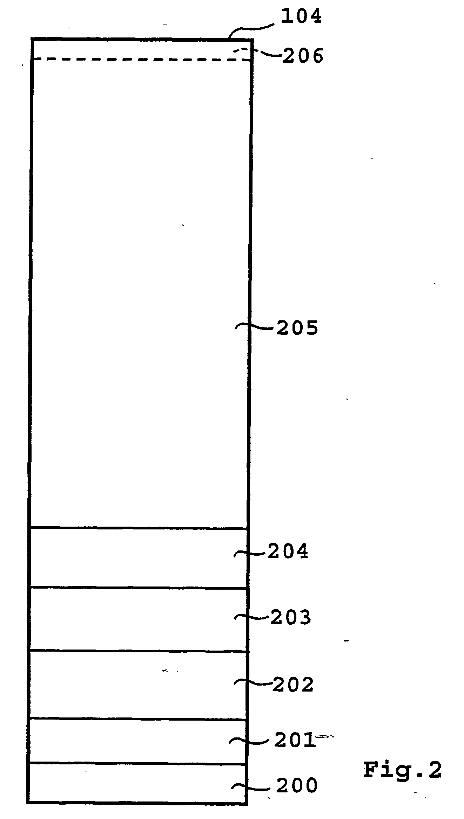

Figur 2 zeigt noch einmal detailliert den löschbaren bzw. programmierbaren nicht flüchtigen Speicher 104. Beispielhaft ist dieser in verschiedene Bereiche 200-205 eingeteilt. 206 stellt daneben lediglich eine Zelle bzw. einen Speicherabschnitt in Speicherbereich 205 dar. Die gezeigte Darstellung der Speicherbelegung dient lediglich der Erläuterung, da eine Vielzahl unterschiedlicher Belegungen des Speichers denkbar ist. Eine mögliche Belegung der Bereiche wird im Weiteren dargestellt. Dabei enthalten beispielsweise die Bereiche 200-203 Vektortabellen und - daten, der Bereich 204 eine Programmierroutine und der Bereich 205 wenigstens ein Anwendungsprogramm. Bei einer internen Programmierung liegen so z.B. in Speicherbereich 200 Bootvektoren mit Einsprüngen in andere Speicherbereiche dieses oder anderer Speicher. Im Bereich 201 sind beispielsweise bestimmte Umschaltfunktionen eingebettet, durch welche eine Ein- und Ausgangskoordination des Speichers beispielsweise mit dem Mikroprozessor 106 erfolgt. Im Bereich 202 liegt beispielsweise eine Startroutine, durch welche beispielsweise der weitere Verlauf je nachdem, ob eine Anwendung oder Programmierung stattfindet, festgelegt wird. Der Bereich 203 ist dabei optional und kann weitere Daten und/oder Routinen enthalten. Im Speicherbereich 204 ist beispielsweise eine Programmierroutine abgelegt, welche durch das Startprogramm im Bereich 202 beispielsweise in das ROM 105 geladen wird und dort seinerseits den weiteren Programmiervorgang steuert. Die Aufteilung in Speicherbereiche wie, sie in Figur 2 vorgeschlagen wird, ist optional, da z.B. bei Verwendung eines externen Programmiergerätes 101 einige der Bereiche 200-205 entfallen können. Eine Programmierung des nicht flüchtigen Speichers 104 erfolgt dabei in der Regel vom untersten zum obersten Speicherbereich, wodurch der Bereich 206 zuletzt programmiert wird.

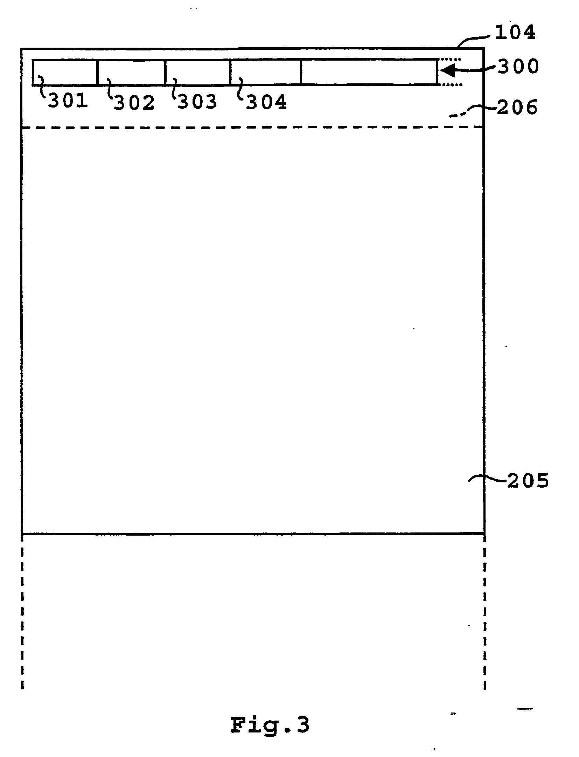

Figur 3 zeigt einen Daten- und/oder Programmabschnitt, insbesondere einer Programmkennung 300 im Speicher 104. Die Programmkennung 300 befindet sich beispielsweise im Speicherbereich 206 des Programmspeicherbereichs 205, da dieser in der Abfolge des Programmiervorgangs spät, vorzugsweise zuletzt programmiert wird. Diese Programmkennung 300 kann in verschiedene Subabschnitte 301-304 unterteilt werden. Ein solcher Subabschnitt 301 -304 kann z.B. eine vorgebbare Anzahl Bitstellen oder eine Kolonne vorgebbarer Länge aus Buchstaben und Zahlen oder beliebigen Zeichen umfassen. Vor bzw. beim Programmiervorgang wird wenigstens ein Subabschnitt, z.B. Subabschnitt 301 als Kennung K ausgewählt und zur späteren Überprüfung abgespeichert. Bei z.B. bereits bekannten Daten und/oder Programmen bzw. bei sich wiederholenden Programmiervorgängen kann aber auch eine bestimmte Kennung in Form eines Subabschnitts fest vorgegeben werden. Daneben kann die Kennung K aber auch aus verschiedenen Daten- und/oder Programmabschnitten bzw. darin enthaltener Subabschnitte zusammengesetzt sein. Diese Subabschnitte, die dann zur Kennung K zusammengefaßt werden können an ganz unterschiedlichen Positionen in den Daten und/oder Programmen ausgewählt werden.

In einem bevorzugten Ausführungsbeispiel wird ein leicht wiederzufindender Daten- und/oder Programmabschnitt, wie z.B. die Programmkennung 300 als Grundlage für die Kennung K ausgewählt, wodurch der oder die als Kennung fungierenden Subabschnitte ebenfalls leicht wieder aufgefunden werden können. Deren genaue Position sollte nach einer Veränderung eben bekannt sein um eine Überprüfung der Kennung K durchführen zu können.

Der Subabschnitt 301 der beispielhaft als Kennung K ausgewählt wurde kann z.B. 6 beliebige Zeichen umfassen. Diese Kennung K , z.B. G47F03, also der Subabschnitt 301 der Programmkennung 300, kann danach ausgewählt werden, daß er besonders unverwechselbar, sprich eindeutig ist. Dann muß die genaue Position des Subabschnitts in den Daten und/oder Programmen nicht genau bekannt sein. Wenn hingegen die Position der Kennung K, eben als erster Subabschnitt 301 der Programmkennung 300 und die Anzahl der Zeichen bzw. Bits, weil vorgebbar, genau bekannt ist kann auch eine Kennung K verwendet werden, die häufiger in den zu programmierenden bzw. programmierten Daten und/oder Programmen vorkommt. Der Übergang dieser Auswahlbedingungen ist dabei fließend. Von besonderem Vorteil kann es sein den zuletzt zu programmierenden Subabschnitt als Kennung K vorzugeben.

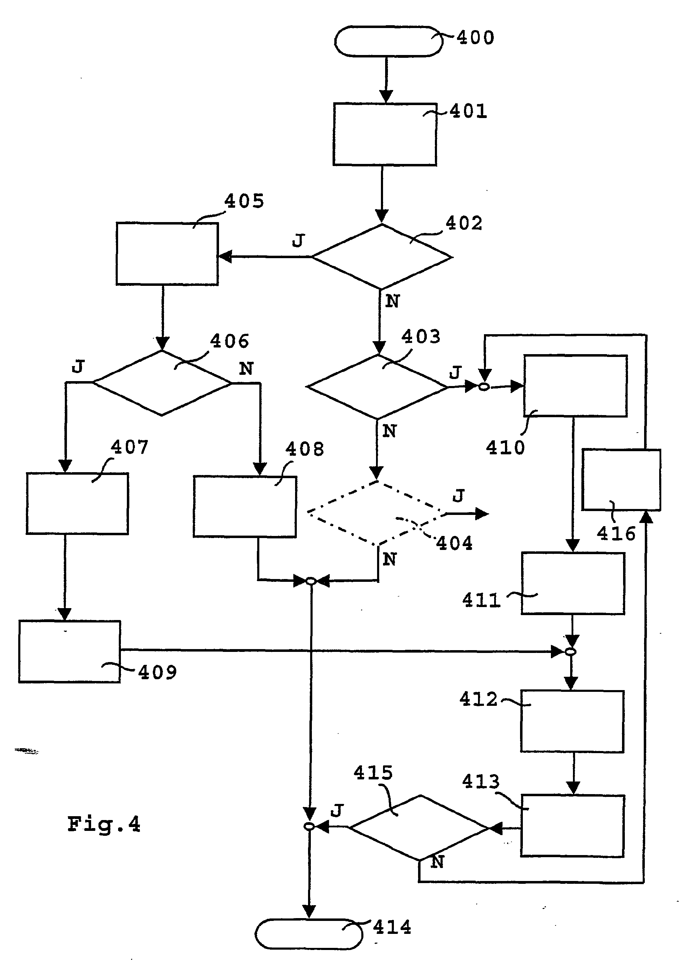

Figur 4 zeigt nun in einem Ablaufdiagramm, wie beispielsweise aus einem aktuellen Programm zum Betrieb des Steuergeräts, insbesondere aus einem Fahrprogramm bei einem Steuergerät zur Steuerung von Betriebsabläufen eines Fahrzeugs, eine Programmierung mit Absicherung eines Speichers, wie beispielsweise der nicht flüchtige Speicher 104, durchgeführt wird. Dies bedeutet, daß bei eingeschaltetem Steuergerät beispielsweise per Softwareprotokoll die Programmiersitzung gestartet wird, automatisch das Betriebssystem gewechselt und anschließend programmiert wird.

Die Absicherung erfolgt dadurch, daß vor dem Löschen bzw. Programmieren des gesamten Speichers oder eines Blocks oder einer Seite je nach Art des eingesetzten Flash-EPROMs am Ende des letzten bestehenden Blocks oder der letzten Seite oder der letzten Zelle des gesamten Speichers eine vorher eingeschriebene Kennung, die das korrekte Löschen und/oder Programmieren des Speichers kenntlich macht, durch Veränderung, beispielsweise durch Löschen oder Überprogrammieren, ungültig, insbesondere unkenntlich, beispielsweise für eine Vergleichs- oder Suchabfrage, gemacht wird. Eine solche Kennung K kann beispielsweise ein mehrstelliger Code aus Buchstaben und Zahlen sein, der z.B. gelöscht oder mit Nullen überschrieben wird. Vorteilhafterweise wird dazu ein ohnehin vorhandener Teil der Daten und/oder Programme beispielsweise der Programmkennung, des sogenannten Programmidentifiers verwendet. Dadurch muß diese Kennung K nicht extra programmiert werden. Erst wenn der gesamte Programmiervorgang bzw. der Lösch- und Programmiervorgang beendet ist und die Kennung K wieder eingeschrieben wurde, ist das Programm wieder gültig. Ereignet sich während des Löschens und/oder Programmierens irgendeine Unterbrechung, ein Reset, oder wird das Gerät anderweitig spannungslos, ist die veränderte Kennung K noch nicht wieder eingeschrieben und somit das Programm nicht gültig und kann somit nicht ausgeführt werden. Dadurch wird aber darüber hinaus diese Unterbrechung im verwendeten Flash-EPROM selbst vermerkt, weil die Kennung K ungültig ist und dies führt dazu, daß bei einem Neustart erst abgefragt werden kann, ob das bestehende Programm lauffähig ist. Sollte die Kennung K ungültig und somit das Programm nicht lauffähig sein, kann automatisch das Betriebssystem zum Programmieren, insbesondere der Bootblock, in einem nicht flüchtigen, nicht löschbaren Speicher wie beispielsweise Speicher 108 in Form eines ROMs oder in einem nicht löschbaren Teil des Flash-EPROM-Speichers 104 selbst, aufgerufen und auf erneutes Programmieren gewartet werden. Somit ist ein nicht oder unvollständig bzw. falsch programmiertes Flash-EPROM 104 kein Hinderungsgrund, der ein erneutes Programmieren verhindert.

In Block 400 in Figur 4 erfolgt der Start des Vorgangs. In Block 401 erfolgt zunächst die Festlegung des abzuarbeitenden Programmes. Diese Auswahl kann aus einer Vielzahl verschiedener Programme und Programmierroutinen getroffen werden. In Bezug auf ein Steuergerät eines Fahrzeugs können dies beispielsweise unterschiedliche Fahrprogramme, wenigstens ein Bootprogramm, usw. sein. Die Festlegung kann dabei durch Vorgabe einer Programmkennung 300, des sogenannten Programmidentifiers, oder auch durch Wahl eines Flags mit einer oder mehreren Bitstellen vorgenommen werden. Diese Vorgabe wird dann in den Abfragen 402,403 bzw. 404 überprüft. Mit Abfrage 404 ist dabei symbolisch der Übergang auf optional weitere Programme dargestellt. Durch Hinzunahme weiterer Abfragen wie 404 und dadurch mögliche weitere Verzweigungen können somit eine Vielzahl von Programmen, insbesondere Fahrprogramme, sowie Bootprogramme oder Programmierroutinen dargestellt werden. Ebenfalls in Block 401 kann dann in einem bevorzugten Ausführungsfall die Kennung K, bzw. der oder die betreffenden Subabschnitte festgelegt werden. Damit kann die Kennung K einerseits für alle Programmiervorgänge festgelegt, z.B. bei sich wiederholenden Programmiervorgängen, oder andererseits pro Programmiervorgang vorgebbar und somit insgesamt variabel sein. In Block 402 wird nun abgefragt, ob durch die Programmkennung bzw. die Flagwahl das Fahrprogramm 1 gewählt wurde. Ist dies der Fall, so gelangt man zu Block 405. In Block 405 wird daraufhin ein Reset ausgelöst, die notwendige Initialisierung für das Fahrprogramm 1 vorgenommen und der Kommunikationsaufbau durchgeführt. Wird in Abfrage 402 festgestellt, daß Fahrprogramm 1 nicht gewählt wurde, so erfolgt beispielsweise in Abfrage 403 die Überprüfung, ob ein Programmierwunsch besteht. Dazu wird in der Verzweigungsstelle 403 abgefragt, ob der Bootblock bzw. das Bootprogramm, als mögliches Anzeichen für eine nachfolgende Programmierung, ausgewählt wurde. Ist dies nicht der Fall, kann in weiteren Abfragen, für die stellvertretend die Abfrage 404 optional dargestellt ist, überprüft werden, welches weitere mögliche Programm ausgewählt wurde. Wurde keines der zur Verfügung stehenden Programme ausgewählt, gelangt man in Block 414 zum Ende des Vorgangs. Andernfalls können ausgehend von der Repräsentativ für weitere Verzweigungen dargestellten Abfrage 404 weitere Programme angesprungen werden. Ist aber in Abfrage 403 ein Bootprogramm, beispielsweise ein Bootprogramm 1, ausgewählt, so gelangt man zu Block 410. Hier erfolgt ebenfalls ein Zurücksetzen auf Anfang (Reset) und eine Bootprogramm 1 abhängige Initialisierung sowie ein Aufbau der Kommunikation. In Block 411 wird daraufhin die Sitzung des Programmiermodus des Programmiergerätes gestartet. Im Block 412 wird daraufhin die Kennung K als Teil des Programmes, insbesondere vorteilhafterweise als Teil der Programmkennung 300, also des Programmidentifiers verändert, insbesondere unkenntlich gemacht. Dabei kann vor der Veränderung der Kennung K, diese sowie ein möglicher Vermerk zu einer Unterbrechung des Programmiervorgangs ausgewertet werden. Ebenso kann die Kennung K erst hier unmittelbar vor der Veränderung der Kennung K durch das Steuergerät 100 bzw. ein Programmiergerät 101 ausgewählt bzw. vorgegeben werden. Zum schnellen Löschen bzw. Programmieren kann dabei in Block 412 eine Baudratenumschaltung durchgeführt werden. Dabei wird von einer geringeren normalen Kommunikationsbitrate auf eine höhere Lösch- und/oder Programmierbitrate umgestellt. In Block 413 erfolgt dann der eigentliche Lösch- bzw. Programmiervorgang, wobei je nach verwendetem Speicher hierbei wie schon genannt beispielsweise seitenweise, blockweise, speicherglobal oder auch zellenweise gelöscht und/oder programmiert werden kann. Am Ende des Programmiervorgangs in Block 413 und/oder nach dem Auftreten einer Unterbrechung, beispielsweise durch eine Störung, einen Reset und/oder einen Stromloszustand des Steuergerätes 100 bzw. des Mikroprozessors 106, des Programmiervorganges wird in Block 415 die Korrektheit der Kennung K überprüft. Wird die Kennung K nicht als korrekt erkannt, erfolgt ein erneuter Einstieg in das unterbrochene Bootprogramm. Dabei kann in einem Block 416 vorgesehen sein, daß ein Vermerk über z.B. Ursache und Zeitpunkt der Unterbrechung in einen Speicher, insbesondere den zu programmierenden Speicher, eingeschrieben wird. Wird die Kennung K hingegen als korrekt identifiziert, gelangt man zu Block 414, dem Ende des Vorgangs. Dies bedeutet, daß auch nach einer vollständigen Programmierung ohne Unterbrechung die Kennung K und/oder ein eventuell vorhandener Vermerk überprüft werden kann. Da die Kennung K in einen Bereich eingeschrieben wird, der möglichst spät, vorteilhafterweise zuletzt programmiert wird, wie der Speicherbereich 206 des Programmbereiches 205 in Figur 2, steht erst bei vollständig und korrekt abgeschlossenem Programmiervorgang erneut eine korrekte Kennung K zur Verfügung.

Aus Sicherheitsgründen kann vorgesehen sein prinzipiell auch zu Beginn eines Anwendungsprogrammes, insbesondere eines Fahrprogrammes eines Fahrzeugs, und eventuell auch zu Beginn eines Programmier- bzw. Bootprogrammes also in den Abfragen 402, 403, 404 ... die Kennung K und eventuell den Vermerk zur Unterbrechung zu überprüfen und auszuwerten. Vorteilhafterweise wird dann in ein Anwendungsprogramm nur eingestiegen wenn einerseits das richtige Programm angewählt ist und daneben ebenfalls die Kennung K und/oder der Vermerk einer Unterbrechung überprüft und als korrekt erkannt wurde. Wenn in ein Bootprogramm, z.B. eine Programmierroutine eingesprungen werden soll, also ohnehin eine Programmierung stattfindet, wird zumindest angezeigt, wenn die Kennung K nicht korrekt ist bzw. ein Vermerk vorliegt. Wenn die Speicherprogrammierung zellen-, seiten- oder blockweise abgesichert und durchgeführt werden soll, kann darüber hinaus überprüft werden ob bei allen nicht zu programmierenden Teilen der Daten und/oder Programmen die Kennung korrekt ist und/oder ein Vermerk vorliegt.

Vor Beginn eines Lösch- bzw. Programmiervorganges, also in diesem Beispiel in Block 412, wird diese Kennung K verändert, insbesondere unkenntlich gemacht. Die erwartete Kennung K ist dabei vorteilhafterweise Bestandteil des Programmes selbst. Wird in Block 401 kein Bootprogramm, sondern beispielsweise ein Fahrprogramm ausgewählt, also ein Anwendungsprogramm, so wird dies in den Abfragen 402, 403, 404 und eventuell Folgenden erkannt. Im Falle des Fahrprogramms 1 gelangt man über Abfrage 402 zu Block 405. Dort werden die bereits oben genannten Vorgänge durchgeführt. In Abfrage 406 wird nun beispielsweise im Zuge der Dienste Bearbeitung im Anwendungsprogramm abgefragt, ob eine Programmiersitzung gestartet werden soll oder nicht. Ist dies nicht der Fall, gelangt man zu Block 408, wo das gewählte Programm, das sich bereits in einem Speicher, insbesondere dem nicht flüchtigen Speicher 104, befindet, abgearbeitet wird und an dessen Ende man wieder zu Block 414, dem Ende des Vorgangs, gelangt. Wird jedoch in Abfrage 406 der Wunsch nach einer Programmierung innerhalb des Anwendungsprogrammes, insbesondere des Fahrprogrammes 1, aufgedeckt, so gelangt man zu Block 407. Abhängig von bestimmten Bedingungen wird dann in Block 407 die Sitzung des Programmiermodus gestartet. Diese Bedingungen sind beispielsweise das nicht Inbetriebsein des Motors, beispielsweise in Verbindung mit einem Default-Mode, die Zustimmung, daß die Syntax in Ordnung ist, insbesondere bei einer verlangten Baudratenumschaltung, usw. Diese Bedingungen können ebenso in Block 411 abgefragt werden. Je nach Einhaltung der Bedingungen werden detailliert unterschiedliche Fehlermeldungen ausgegeben. Sind diese Bedingungen für den Programmiermodus allerdings erfüllt, werden unter anderem Quell- und Zieladresse in einen anderen Speicher bzw. Speicherbereich gerettet, sowie ein Software-Reset eingeleitet. An dieser Stelle kann auch ein Code gesetzt werden, welcher angibt, daß eine Programmierung des nicht flüchtigen Speichers, insbesondere des Flashspeichers 104 durchgeführt werden soll. Schlägt nun der Software-Reset zu, wird nach dem Reset eine Initialisierung durchgeführt und der eingegebene Code für die Flash-Programmierung überprüft. Ist dieser Code korrekt, wird dieser beispielsweise ebenfalls gezielt verändert, um später aufgrund dieser Aktion erneut identifiziert zu werden. Dies kann beispielsweise durch ein Verschieben des Codes um ein Bit nach rechts erfolgen. Aber auch andere Maßnahmen sind denkbar. Im Anschluß daran erfolgt der Funktionsaufruf zum Aufsetzen der Kommunikation, was in Block 409 geschieht. In Block wird nun die Kommunikation bezüglich des Bootprogrammes aufgesetzt. Dazu darf diese nicht schon vorhanden sein und der gezielt veränderte Code muß erkannt werden. Daraufhin erfolgt in Block 409 eine Initialisierung wie beim Kommunikationsstart im Bootprogramm bzw. Bootblock in Block 410. Ebenso erfolgt hierbei das Initialisieren der Schnittstelle mit einer normalen Kommunikationsübertragungsrate, dem Einstellen des Sendens des Aktivsetzens der Kommunikation, usw. Ebenfalls beim Aufsetzen der Kommunikation wird beispielsweise ein Flag für die Baudratenumschaltung gesetzt, damit unmittelbar nach dem Senden der positiven Antwort im Kommunikationsverlauf die Übertragungsrate bzw. Baudrate in Block 412 wieder umgeschaltet werden kann. Ebenso wird hier die Sitzung des Programmiermodus aktiv gesetzt. Nach der positiven Antwort im Zuge des Kommunikationsaufsetzens wird diese in einen Puffer geschrieben und der Sendevorgang angestoßen. Daraufhin gelangt man zu Block 412 und mit der Baudratenumschaltung beginnt wieder der weitere Ablauf im Bootprogramm.

## Patentansprüche

1. Verfahren zum Löschen und/oder Programmieren von Daten und/oder Programmen in einem nicht-flüchtigen Speicher (104) eines Rechners (100), insbesondere eines Steuergerätes in einem Fahrzeug, wobei bei der Programmierung eine Kennung (K), die das korrekte Löschen und/oder Programmieren (413) des Speichers (104) kenntlich macht in einen zu löschenden und/oder zu programmierenden Bereich (206) des Speichers (104) eingeschrieben wird, **dadurch gekennzeichnet, dass** in einem ersten Schritt durch ein Überprogrammieren die eingeschriebene Kennung (K) in dem Speicher (104) vor einem zweiten folgenden Schritt des Löschens und/oder Programmierens der Daten und/oder Programme (413) unkenntlich gemacht wird (412), wobei durch die korrekte Programmierung die Kennung wieder kenntlich gemacht wird, so dass diese erst nach abgeschlossener Programmierung wieder aufgefunden werden kann und die eingeschriebenen Daten und/oder Programme nur ausgeführt werden, wenn die Kennung nach der Programmierung als korrekt erkannt wird.

2. Verfahren nach Anspruch 1, **dadurch gekennzeichnet, dass** die Kennung (K), die das korrekte Löschen und/oder Programmieren (413) des Speichers (104) kenntlich macht in einen spät zu löschenden und/oder zu programmierenden Bereich (206), insbesondere einen als letztes zu löschenden und/oder zu programmierenden Bereich, des Speichers (104) eingeschrieben wird.

3. Verfahren nach Anspruch 1, **dadurch gekennzeichnet, dass** die Kennung (K) als Daten und/oder Programmbestandteil. (301) ausgebildet ist.

4. Verfahren nach Anspruch 3, **dadurch gekennzeichnet, dass** die Kennung (K) als wenigstens ein Abschnitt (301) vorgebbarer Länge der in den Speicher (104) eingeschriebenen Daten und/oder Programme ausgewählt wird bzw. vorgebbar ist.

5. Verfahren nach Anspruch 1, **dadurch gekennzeichnet, dass** die Kennung (K) als Abschnitt (301) einer Programmkennung (300), die die jeweiligen Daten und/oder Programme kennzeichnet, ausgebildet ist.

6. Verfahren nach Anspruch 1, **dadurch gekennzeichnet, dass** die Kennung (K) nach einer Unterbrechung des Löschens und/oder Programmierens und/oder nach dem Löschen und/oder Programmieren des Speichers (104) überprüft wird (415).

7. Verfahren nach Anspruch 6, **dadurch gekennzeichnet, dass** die Unterbrechung des Löschens und/oder Programmierens des Speichers im Speicher durch einen Vermerk abgelegt wird (416).

8. Verfahren nach einem der vorhergehenden Ansprüche, **dadurch gekennzeichnet, dass** vor dem Löschen und/oder Programmieren die Kennung und/oder der Vermerk überprüft und ausgewertet werden.

9. Rechner (100), insbesondere Streuergerät in einem Fahrzeug, mit einem nicht-flüchtigen Speicher (104) und einer Vorrichtung zum Löschen und/oder Programmieren von Daten und/oder Programmen in dem nicht-flüchtigen Speicher (104) mit einem Mittel zur Programmierung (101, 106) das eine Kennung (K), die das korrekte Löschen und/oder Programmieren (413) des Speichers (104) kenntlich macht in einen zu löschenden und/oder zu programmierenden Bereich (206) des Speichers (104) einschreibt, **dadurch gekennzeichnet, dass** das Mittel zur Programmierung (101, 106)in einem ersten Schritt durch Überprogrammieren die eingeschriebene Kennung (K) in dem Speicher (104) vor einem zweiten nachfolgenden Schritt des Löschens und/oder Programmierens der Daten und/oder Programme (413), unkenntlich macht (412), wobei dieses Mittel die Kennung durch die korrekte Programmierung wieder kenntlich macht, so dass die Kennung erst nach abgeschlossener Programmierung wieder aufgefunden werden kann und der Rechner die eingeschriebenen Daten und/oder Programme nur ausführt, wenn die Kennung nach der Programmierung als korrekt erkannt wird.

## Claims

1. Method for erasing and/or programming data and/or programs in a non-volatile memory (104) of a computer (100) in particular of a control unit in a vehicle, wherein, during programming, an identifier (K), by which the correct erasing and/or programming (413) of the memory (104) is made identifiable, is written to an area (206) of the memory (104) that is to be erased and/or programmed, **characterized in that**, in a first step, by means of overprogramming, the written identifier (K) is made unidentifiable (412) in the memory (104) before a second subsequent step of erasing and/or programming the data and/or programs (413), wherein the identifier is made identifiable again by the correct programming, such that said identifier can be retrieved only after programming has been concluded, and the written data and/or programs are only executed if the identifier is identified as correct after programming.

2. Method according to Claim 1, **characterized in that** the identifier (K), by which the correct erasing and/or programming (413) of the memory (104) is made identifiable, is written to an area (206) that is to be erased and/or programmed late, in particular an area that is to be erased and/or programmed last, of the memory (104).

3. Method according to Claim 1, **characterized in that** the identifier (K) is embodied as data and/or program constituent (301).

4. Method according to Claim 3, **characterized in that** the identifier (K) is selected or can be predefined as at least one section (301) of predefinable length of the data and/or programs written to the memory (104).

5. Method according to Claim 1, **characterized in that** the identifier (K) is embodied as a section (301) of a program identifier (300), which identifies the respective data and/or programs.

6. Method according to Claim 1, **characterized in that** the identifier (K) is checked (415) after an interruption of erasing and/or programming and/or after the erasing and/or programming of the memory (104).

7. Method according to Claim 6, **characterized in that** the interruption of the erasing and/or programming of the memory is stored (416) in the memory by means of a note.

8. Method according to any of the preceding claims, **characterized in that** the identifier and/or the note are/is checked and evaluated prior to erasing and/or programming.

9. Computer (100), in particular control unit in a vehicle, comprising a non-volatile memory (104) and an apparatus for erasing and/or programming data and/or program in the non-volatile memory (104) comprising a means for programming (101, 106), which writes an identifier (K), by which the correct erasing and/or programming (413) of the memory (104) is made identifiable, to an area (206) of the memory (104) that is to be erased and/or programmed, **characterized in that** the means for programming (101, 106), in a first step, by overprogramming, makes unidentifiable (412) the written identifier (K) in the memory (104) prior to a second subsequent step of the erasing and/or programming of the data and/or programs (413), wherein said means makes the identifier identifiable again by the correct programming, such that the identifier can only be retrieved after programming has been concluded, and the computer executes the written data and/or programs only if the identifier is identified as correct after programming.

## Revendications

1. Procédé pour effacer et/ou programmer des données et/ou des programmes dans une mémoire non volatile (104) d'un calculateur (100) et en particulier d'un appareil de commande prévu dans un véhicule, une caractéristique (K) qui permet de déceler l'effacement correct et/ou la programmation (413) de la mémoire (104) étant inscrite lors de la programmation dans une partie à effacer et/ou à programmer (206) de la mémoire (104),
**caractérisé en ce que**
dans une première étape, par sur-programmation, la caractéristique (K) inscrite dans la mémoire (104) est rendue indécelable (412) avant une deuxième étape ultérieure d'effacement et/ou de programmation des données et/ou programme (413), la programmation correcte rendant de nouveau détectable la caractéristique de telle sorte que cette dernière ne peut être redécouverte que lorsque la programmation est terminée et que les données et/ou les programmes inscrits ne peuvent être exécutés que si la caractéristique est détectée comme correcte après la programmation.

2. Procédé selon la revendication 1, **caractérisé en ce que** la caractéristique (K) qui rend détectable l'effacement correct et/ou la programmation correcte (413) de la mémoire (104) est inscrite dans une partie (206) qui doit être effacée et/ou programmée ultérieurement, en particulier la dernière partie à effacer et/ou à programmer, de la mémoire (104).

3. Procédé selon la revendication 1, **caractérisé en ce que** la caractéristique (K) est configurée comme données et/ou comme composants (301) du programme.

4. Procédé selon la revendication 3, **caractérisé en ce que** la caractéristique (K) peut être sélectionnée ou prédéterminée en tant que partie ou parties (301) de longueur prédéterminée des données et/ou programmes inscrits dans la mémoire (104).

5. Procédé selon la revendication 1, **caractérisé en ce que** la caractéristique (K) est configurée comme partie (301) d'une caractéristique de programme (300) qui caractérise les données et/ou programmes particuliers.

6. Procédé selon la revendication 1, **caractérisé en ce que** la caractéristique (K) est vérifiée (415) après une interruption de l'effacement et/ou de la programmation et/ou après l'effacement et/ou la programmation de la mémoire (104).

7. Procédé selon la revendication 6, **caractérisé en ce que** l'interruption de l'effacement et/ou de la programmation de la mémoire est conservée (416) dans la mémoire par une remarque.

8. Procédé selon l'une des revendications précédentes, **caractérisé en ce que** la caractéristique et/ou la remarque sont vérifiées et évaluées avant l'effacement et/ou la programmation.

9. Calculateur (100), en particulier appareil de commande prévu dans un véhicule, présentant une mémoire non volatile (104) et un dispositif d'effacement et/ou de programmation de données et/ou de programmes dans la mémoire non volatile (104), le dispositif présentant
des moyens de programmation (101, 106) qui inscrivent dans une partie (206) à effacer et/ou à programmer de la mémoire (104) une caractéristique (K) qui rend décelables l'effacement correct et/ou la programmation correcte (413) de la mémoire (104), **caractérisé en ce que**
dans une première étape, par sur-programmation, les moyens de programmation (101, 106) rendent indécelable (412) la caractéristique (K) inscrite dans la mémoire (104) avant une deuxième étape ultérieure d'effacement et/ou de programmation des données et/ou programmes (413), ce moyen rendant de nouveau décelable la caractéristique par la programmation correcte, de sorte que la caractéristique ne puisse être redécouverte qu'après que la programmation est terminée et que le calculateur n'exécute les données et/ou programmes inscrits que si la caractéristique a été reconnue comme correcte après la programmation.
